# EUROPEAN PATENT SPECIFICATION

(11) **EP 0 361 462 B1**
(45) Date of publication and mention of the grant of the patent: **06.04.1994**
(21) Application number: 89117909.5
(22) Date of filing: 28.09.1989
(51) Int. Cl.: H05K 1/03, H01B 3/30, C08G 73/10, H01B 1/22, H01L 23/14

(54) **Process for producing copper or silver/polyimide composite article**
Verfahren zur Herstellung eines aus Kupfer oder Silber/Polyimid zusammengesetzten Artikels
Procédé de production d'un article composé de cuivre ou argent/polyimide

(30) Priority: 28.09.1988 JP 240998/88
(43) Date of publication of application: 04.04.1990
(73) Proprietor: HITACHI, LTD., Chiyoda-ku, Tokyo 101 (JP); NITTO DENKO CORPORATION, Osaka (JP)
(72) Inventor: Miyazaki, Kunio, Hitachi-shi (JP); Miura, Osamu, Hitachi-shi (JP); Watanabe, Ryuji, Naka-gun Ibaraki-ken (JP); Ookoshi, Yukio, Mito-shi (JP); Miyamoto, Toshio, Takasaki-shi (JP); Aizawa, Mikio, Fukaya-shi (JP); Igarashi, Kazumasa, Suzuka-shi (JP); Mochizuki, Amane, Fukaya-shi (JP)
(74) Representative: Beetz & Partner Patentanwälte

(56) References cited:
- EP-A- 0 116 297
- EP-A- 0 130 417
- EP-A- 0 143 531
- EP-A- 0 247 358
- EP-A- 0 251 828
- FR-A- 1 571 736
- US-A- 4 454 220

## Description

The present invention relates to a process for producing copper or silver/polyimide composite articles and particularly printed circuit boards and copper or silver/polyimide compositions, including wiring boards exhibiting a very small delay time for use in large sized to middle or small sized computers, and flexible printed boards which are essential for the miniaturization of electronic parts.

Hitherto, there have been used multi-layer wiring boards comprising an epoxy or maleimide resin-glass cloth laminate and copper film or alumina/tungsten multi-layer wiring boards. However, in the former case, there are limitations in the production method and the materials, and a fine wire width of less than 30 µm cannot be obtained; in the latter case, tungsten of high heat resistance with high resistivity must be used because ceramics have a high dielectric constant,and very high temperatures are required for production. Thus, wiring boards of high performance have been demanded as future high speed and high density wiring boards to be used in place of the above conventional wiring boards.

Copper/polyimide wiring boards have been produced by forming a polyimide of low dielectric constant and copper of low resistivity on a silicon wafer or a ceramic substrate by the same fining process as used for the production of semiconductor wirings. By this method, it can be expected that wiring boards of high performance are obtained. For this conventional technique, polyimide laminate materials are disclosed in JP-57-181857.

However, there is the problem that when a polyamic acid, which is a polyimide precursor, is heated and cured in contact with copper or silver at a temperature higher than 300°C, heat decomposition reactions occur which cannot be considered to occur in view of the heat resistance of polyimide per se. For example, it has been known that when a polyamic acid varnish is coated on a film of copper and heat cured, a distinct discoloration occurs at temperatures higher than 300°C, and the film becomes mechanically very brittle. Similar phenomena are recognized to occur in the production of flexible printed boards or during the curing of electrically conductive silver pastes. This problem is especially conspicuous for copper and silver, whereas nearly no problems arise when aluminum, titanium, nickel or chromium are used.

Up to now, in forming an imidized film in contact with a metal, the following methods have been employed: A method of forming a metallic film such as of inert chromium or an inert film of SiO₂ or Si₃N₄ and coating thereon a polyamic acid precursor varnish and heating and curing the varnish, and a method of heating and curing the varnish in a reducing atmosphere such as hydrogen when the varnish is allowed to directly contact with the metal. These methods suffer from severe problems such as the much increased number of steps and the increased running cost.

Based on the fact that even if a film of such a metal is formed on a polyimide film and heated, substantially no adverse effect is occuring with the polyimide film, the inventors coated a varnish of a polyimide on a metallic film and heated and cured the varnish, and as a result have found that no deterioration of the polyimide occurs. However, this method still has the problems that since the solubility of the polyimide is very poor, cresol type solvents which are harmful to the human body must be used, since only special solvents can be used.

In connection with the invention, the chemical reaction between the polyimide precursor and the metal which takes place in the production of metal/polyimide composites which includes a step of thermal imidization of the polyimide precursor in contact with the metal, have been carefully studied. As a result, it has been elucidated that the metal is dissolved in the presence of carboxylic acid groups of the polyamic acid, and subsequently, when it is exposed to high temperature, imide rings are decomposed by the metal, and simultaneously particulate metal oxide is precipitated in the polyimide film. Furthermore, it has also been found that similar phenomena occur with polyimide precursors having sulfonic acid groups, wherein the presence of acidic functional group causes dissolution of metal.

It is the object of the present invention to provide a process for producing copper or silver/polyimide composite articles of high reliability which are free from heat deterioration of the polyimide film due to metal ions of the metal film with which the polyimide film is in contact.

The above object is achieved according to the independent claims. Claim 5 relates to a preferred embodiment.

It has been found that if a polyamic acid whose carboxylic acid groups are masked in the form of ester groups such as alkyl ester groups, no problem occurs. These esterified polyamic acids can be obtained by, for example, reaction of an acid anhydride with an alcohol, then conversion of the product into an acid chloride with thionyl chloride, and then further reaction of the acid chloride with a diamine, or by polycondensation of a half ester of a tetracarboxylic acid and a diamine with a dehydrating agent.

The present invention provides a process for producing copper or silver/polyimide composite articles comprising the steps of providing a precursor of a polyimide in contact with the copper or silver, and
heating the precursor until it turns into the polyimide, wherein the precursor is a polyamic acid ester represented by the following general formula I, 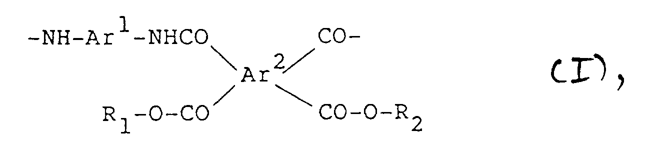
wherein R₁ and R₂ are each the same or different organic groups having one or more, carbon atoms, Ar¹ is a bivalent aromatic group, and Ar² is a tetravalent aromatic group.

Ester masked polyamic acids of this type have been known from EP-A-251 828, however, this document relates to a process for producing semiconductor devices wherein an aluminum interconnection layer is covered by an insulating polyimide film made of the masked polyamic acid as polyimide precursor. In this process, the precursor of the polyimide is provided in contact with the aluminum layer and heated until it turns into the polyimide.

The above-mentioned problems of decomposition of the polyimide do not occur in the case of aluminum.

The present invention further provides a process for producing printed circuit boards, comprising the steps of
forming a copper film on an electrically insulating substrate,
coating a precursor of a polyimide on the copper film, and
heating the precursor until it turns into the polyimide,
wherein the precursor is the polyamic acid ester of the above-indicated general formula I.

According to on other aspect of the present invention, there is provided a process for producing a copper or silver/polyimide composition comprising the steps of
providing a homogeneous mixture of a precursor of a polyimide, minute particles of copper or silver
and an organic solvent for dissolving the precursor, and
heating the precursor until it turns into the polyimide,
wherein the precursor is a polyamic acid ester represented by the above-indicated general formula I.

According to still another aspect, the present invention provides a process for producing multi-layer printed circuit boards which comprises the following steps :
(A) Forming a circuit pattern of a copper film on an electrically insulating substrate;
(B) coating a varnish of a precursor of a polyimide on the circuit pattern;
(C) heating the varnish until the precursor turns into the polyimide;
(D) patterning the polyimide to form through-holes therein, and
(E) forming a circuit pattern of copper on the patterned polyimide,
the steps A through E being repeated until a desired number of layers is obtained, wherein the precursor is a polyamic acid ester represented by the above-indicated general formula I.

The number of carbon atoms of each of the substituents R₁ and R₂ is preferably 1 to 20.

The present invention is based on the principle that the precursor of the polyimide is substantially free from carboxyl groups.

The polyamic acid ester varnish used in the present invention can be obtained by homopolymerizing an aminodicarboxylic acid ester to obtain a polyamic acid, or by reaction of an aromatic diamine with a tetracarboxylic acid derivative to obtain a polyamic acid, and then heating the resulting polyamic acid in an organic solvent containing alcohol to esterify the polyamic acid. The tetracarboxylic acids and their derivatives include esters, acid anhydrides and acid chlorides. Acid chlorides are preferred from the point of view of preparation.

The reaction for preparing the polyamic acids is generally carried out at -20 to 200°C in solvents such as N-methylpyrrolidone (NMP), dimethylformamide (DMF), dimethylacetamide (DMAC), dimethylsulfoxide (DMSO), dimethyl sulfate, sulforan, butyl lactone, cresol, phenol, halogenated phenol, cyclohexanone, dioxane, tetrahydrofuran, and acetophenone.

Examples of aminodicarboxylic acids and their derivatives which may be used in the present invention include 4-aminophthalic acid, 4-amino-5-methylphthalic acid, 4-(p-anilino)-phthalic acid and 4-(3,5-dimethyl-4-anilino)-phthalic acid and esters, acid anhydrides and acid chlorides thereof.

Examples of aromatic diamines which may be used in the present invention are p-phenylenediamine (p-PDA), 2,5-diaminotoluene, 2,5-diaminoxylene, diaminodurene-(2,3,5,6-tetramethylphenylenediamine), 2,5-diamino-benzotrifluoride, 2,5-diaminoanisole, 2,5-diaminoacetophenone, 2,5-diaminobenzophenone, 2,5-diaminodiphenyl, 2,5-diaminofluorobenzene, benzidine, o-tolidine (o-TLD), m-tolidine, 3,3',5,5'-tetramethylbenzidine, 3,3'-dimethoxybenzidine, 3,3'-di(trifluoromethyl)benzidine, 3,3'-diacetylbenzidine, 3,3'-difluorobenzidine, octafluorobenzidine, 4,4''-diaminoterphenyl DATP), and 4,4'''-diaminoquaterphenyl which have linear conformations, and m-phenylenediamine, 4,4'-diaminodiphenylmethane, 1,2-bis(anilino)ethane, 4,4'-diaminodiphenyl ether (DDE), diaminodiphenylsulfone, 2,2-bis(p-aminophenyl)propane, 2,2-bis(p-aminophenyl)hexafluoropropane, 3,3'-dimethyl-4,4'-diaminodiphenyl ether, 3,3'-dimethyl-4,4'-diaminodiphenylmethane, diaminotoluene, diaminobenzotrifluoride, 1,4-bis(p-aminophenoxy)benzene, 4,4-bis(p-aminophenoxy)-biphenyl, 2,2-bis{4-(p-aminophenoxy)-phenyl}propane (DAPP), 2,2-bis{4-(m-aminophenoxy)-phenyl}propane, 2,2-bis{4-(p-aminophenoxy)-phenyl}hexafluoropropane (DAPFP), 2,2-bis{4-(m-aminophenoxy)phenyl}hexafluoropropane, 2,2-bis{4-(p-aminophenoxy)-3,5-dimethylphenyl}hexafluoropropane, 2,2-bis{4-(p-aminophenoxy)-3,5-bis{trifluoromethylphenyl}hexafluoropropane, p-bis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)biphenylsulfone, 4,4'-bis(3-amino-5-trifluoromethylphenoxy)biphenylsulfone, 2,2-bis{4-(p-amino-3-trifluoromethylphenoxy)-phenyl}-hexafluoropropane, diaminoanthraquinone, 4,4-bis(3-aminophenoxyphenyl)diphenylsulfone, 1,3-bis(anilino)hexafluoropropane, 1,4-bis(anilino)octafluorobutane, 1,5-bis(anilino)decafluoropentane and 1,7-bis(anilino)tetradecafluoroheptane. Moreover, diaminosiloxanes represented by the formula II, 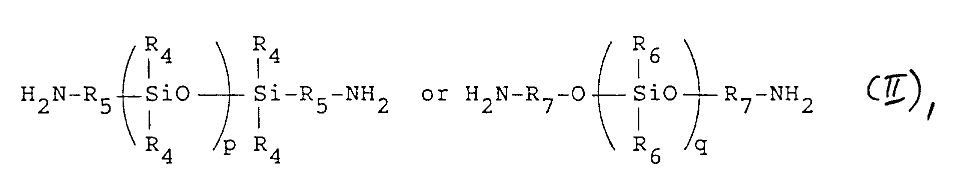
wherein R₅ and R₇ each represent a divalent organic group, R₄ and R₆ each represent a monovalent organic group, and p and q each represent an integer of more than 1, may also be used as diamines.

As the tetracarboxylic acids and their derivatives used in the present invention, mention may be made of, for example, pyromellitic acid (PMDA), methylpyromellitic acid, dimethylpyromellitic acid, bis(trifluoromethyl)pyromellitic acid, 3,3',4,4'-tetracarboxybiphenyl (s-BPDA), 5,5'-dimethyl-3,3',4,4'-tetracarboxybiphenyl, p-(3,4-dicarboxyphenyl)-benzene, 2,3,3',4'-tetracarboxybiphenyl, 3,3',4,4'-tetracarboxydiphenyl ether, 2,3,3',4'-tetracarboxydiphenylether, 3,3',4,4'-tetracarboxybenzophenone (BTDA), 2,3,3',4'-tetracarboxybenzophenone, 2,3,6,7-tetracarboxynaphthalene, 1,4,5,7-tetracarboxynaphthalene, 1,2,5,6-tetracarboxynaphthalene, 3,3',4,4'-tetracarboxydiphenylmethane, 2,3,3',4'-tetracarboxydiphenylmethane, 2,2-bis(3,4-dicarboxyphenyl)propane, 2,2-bis(3,4-dicarboxyphenyl)hexafluoropropane, 3,3',4,4'-tetracarboxydiphenylsulfone, 3,4,9,10-tetracarboxyperilene, 2,2-bis{4-(3,4-dicarboxyphenoxy)-phenyl}propane, 2,2-bis{4-(3,4-dicarboxyphenoxy)-phenyl}hexafluoropropane, butanetetracarboxylic acid, and cyclopentanetetracarboxylic acid. Acid anhydrides, acid chlorides and esters may also be used.

The polyamic acid alkyl esters used according to the processes of the present invention can be obtained by reacting the above acid anhydride with an alcohol, then reacting the product with a chlorinating agent such as thionyl chloride to obtain the acid chloride and thereafter reacting the chloride with a diamine or by polycondensation of an esterified tetracarboxylic acid with a diamine using a dehydrating agent.

The polyamic acid esters used in the processes of the present invention have such merits as very excellent solubility, low viscosity of varnishes, and excellent stability.

Coating films can be formed from the polyamic acid ester varnish by generally employed methods such as spin coating. In the formation of films, preferably the polyamic acid ester is first dried at 50-250°C and then imidized by heating to 250-400°C.

In the processes of the present invention, the adhesion of the polyimide to various substrates is important. It is preferred to roughen the surface of inorganic materials or to treat the surface with a silane coupling agent, a titanate coupling agent, an aluminum alcoholate, an aluminum chelate, a zirconium chelate, or with aluminum acetylacetonate. These surface treating agents may be added to the polyimide. Alternatively, diamines having a siloxane skeleton or tetracarboxylic acid dianhydrides may be copolymerized therewith.

In the processes of the present invention, when the polyimide skeleton has a linear conformation, the heat expansion coefficient of the film is very small and the modulus thereof is increased, but it is also possible to decrease the heat expansion coefficient, to increase the modulus and to control the flowability by incorporating therein powders, fibers, chopped strands or the like of inorganic materials, organic materials or metals.

It has been ascertained that when a polyimide film is formed from a usual precursor in contact with copper or silver, the metal is dissolved in the polyamic acid which is a precursor of polyimide. The metal ions dissolved from the metallic substrate act as a catalyst for the thermal decomposition of the polyimide under the high temperature conditions applied for curing, but the masked polyamic acid used in the processes of the present invention prevents the dissolution of metal, because there are no free carboxylic acid groups. As a result, a deterioration of the polyimide film can be prevented.

In the following, the situation will be explained with further details with reference to the drawings.
Fig. 1 illustrates a high-density wiring board which is one specific example of the present invention;
Fig. 2 illustrates an example of the application of the present invention to a package substrate for multi-chip modules.

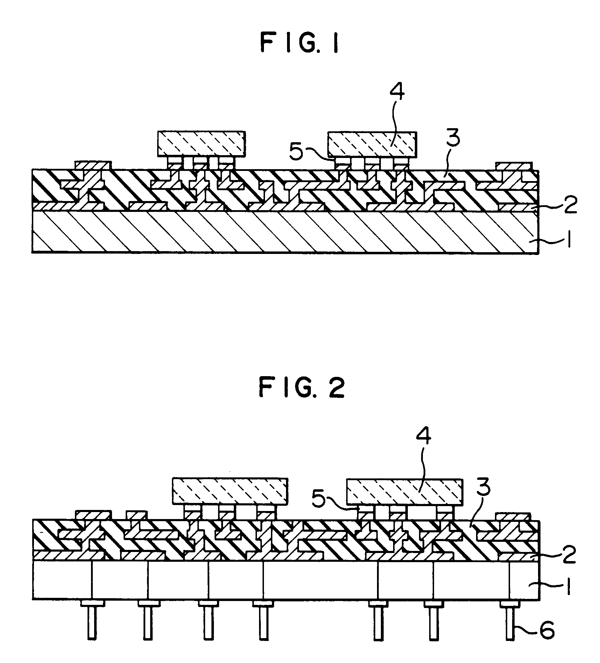

The present invention may be applied to the production of multi-chip modules shown in Figs. 1 and 2. A pattern of a copper film 2 is formed on an insulating substrate or circuit board 1 by vacuum evaporation. The patterning of the copper film is performed by chemical etching or dry etching which are well known in the art.

A varnish of a precursor (i.e. a polyamic acid ester) of a polyimide is coated on the patterned copper film 2, then the coating of the precursor is dried and heated to effect the imidization of the precursor. The polyimide film 3 is then patterned to form one or more through-holes by etching with hydrazine or by dry etching by means of an ion milling apparatus. Another copper film is then deposited on the patterned polyimide film so that the lower copper film and upper copper film are electrically connected. Then, the upper copper film is patterned thereby to form the desired circuits. After the desired number of layers of copper films 2 and polyimide films 3 has been formed, semiconductor chips 4 are bonded to the patterned copper film 2 through CCB 5.

Fig. 2 shows an LSI package of ceramic pin grid array type comprising pins 6 in which the multi-layer circuit board comprising the copper films 2 and the polyimide film 3 is produced in the same manner as in Fig. 1.

### Example 1

s-BPDA was made to react with methanol at a molar ratio of 1:2 in N-2-methylpyrrolidone (abbreviated to "NMP" hereinafter) to obtain a half-esterified product. This was reacted with thionyl chloride by a conventional method to obtain the acid chloride. Thereto were added triethylamine and DDE, and the reaction was allowed to proceed for 2 hours at room temperature and further for 2 hours at 50°C. The reaction mixture was then poured in to a large amount of water to obtain the desired polyamic acid methyl ester.

This polyamic acid methyl ester was dried and then again dissolved in NMP to produce a 15% varnish. This polyamic acid methyl ester varnish was spin coated onto the surface of a silicon wafer having thereon a vapor-deposited thin copper film of a thickness of 10µm.

The heating conditions for the imidization were heating at 100°C for 30 minutes, heating from 100°C to 350°C over 1 hour, and keeping at that temperature for 30 minutes. The heating atmosphere was air. This polyimide film was then peeled from the silicon wafer, and the copper content in this film, the color, the heat decomposition temperature and the tensile strength were measured. It was found that this film contained only 0.05% (atomic-absorption method) of copper, the color of the film was yellowish orange, and this was nearly the same as with a film formed on an inert SiO₂ film as substrate. The decomposition temperature in air was 450°C, the tensile strength was 105 MPa, and the breaking extension was 35%, showing that this was a very excellent film.

### Example 2

BTDA was made to react with ethanol at a molar ratio of 1:2 in NMP to obtain a half-esterified product. This was mixed with p-PDA and thereto was added dicyclohexylcarbodiimide in an amount of 1.2 time the mole number of amino groups, and the polycondensation was carried out. The reaction mixture was then poured in to a large amount of water to obtain the desired polyamic acid ethyl ester.

This polyamic acid ethyl ester was dried and then again dissolved in NMP to produce a 15% varnish. This polyamic acid ethyl ester varnish was spin coated onto the surface of a silicon wafer having a vapor-deposited thin copper film on the surface in the same manner as in Example 1 to form a film of a thickness of 10 µm. The heating conditions for the imidization were the same as in Example 1. This polyimide film was then peeled from the silicon wafer by etching the copper foil, and the copper content in this film, the color, the heat decomposition temperature and the tensile strength were measured. As a result, this film contained only 0.03% of copper, and the color of the film was yellowish orange, and this was nearly the same as with a film formed on an inert SiO₂ film as substrate. The decomposition temperature in air of this film was 450°C, the tensile strength was 250 MPa, and the breaking extension was 13%, showing that this film had very excellent heat resistance and mechanical properties.

### Example 3

The polyamic acid ethyl ester varnish prepared in Example 2 was spin coated on the surface of a silicon wafer having a vapor-deposited thin silver film thereon to form a film of a thickness of 10µm. The heating for the imidization were the same as in Example 1, and the atomosphere was air. This polyimide film was then peeled from the silicon wafer, and the content of silver in this film, and the color, the heat decomposition temperature and the tensile strength were measured. This film contained only 0.011% (atomic-absorption method) of silver and had a yellowish orange color which was nearly the same as that of a film formed on an inert SiO₂ film as substrate. The decomposition temperature of this film in air was 455°C, the tensile strength was 260 MPa, and the breaking extension was 19%, showing that this film had very excellent heat resistance and mechanical properties.

### Comparative Example 1

DAPP was made to react with BTDA in cresol at room temperature to produce the polyamic acid, and then, the reaction was allowed to proceed at 150°C for 3 hours to obtain a varnish.

This varnish was spin coated onto the surface of a silicon wafer having a vapor-deposited thin copper film on the surface to form a film of a thickness of 10 µm. The heating conditions for the imidization were heating at 150°C for 30 minutes, heating from 150°C to 350°C over 1 hours, and keeping at that temperature for 30 minutes. The atmosphere was air. This polyimide film was then peeled from the silicon wafer, and the copper content in this film, the color, the heat decomposition temperature and the tensile strength were measured. As a result, this film contained only 0.03% of copper, and the color of the film was yellowish orange, which was nearly the same as that of a film formed on an inert SiO₂ film as substrate (Comparative Example 2). The decomposition temperature in air of this film was 410°C, the tensile strength was 120 MPa, and the breaking extension was 30%, showing that this film had very excellent heat resistance and mechanical properties.

Furthermore, this film was dipped in an etching solution for copper for about 5 hours, and then the heat decomposition temperature and the mechanical properties of the film were measured to obtain nearly the same values as those of the film which was not dipped in the etching solution, and thus the film was found to be chemically very stable.

However, the film was considerably inferior to that of Comparative Example 2 in heat resistance and mechanical properties. This is not due to a deterioration of the polyimide, but due to the fact that when the solubility in solvent is enhanced, the molecule skeleton becomes flexible, and the film thus becomes inferior in heat resistance and mechanical properties.

### Comparative Example 2

A 15% NMP solution of a polyamic acid obtained from p-PDA and s-BPDA was spin coated on to the surface of a silicon wafer on which a silicon oxide film had been formed, to form a film of a thickness of 10 µm. The heating conditions for the imidization were the same as in Example 1. This film was then peeled from the silicon wafer, and the color, the heat decomposition temperature and the tensile strength were measured. As a result, this film had a yellowish orange color. The decomposition temperature of this film in air was 510°C, the tensile strength was 350 MPa, and the breaking extension was 25%, showing that this film had very excellent heat resistance and mechanical properties. The copper content in this film was naturally very low and less than 0.0003%.

Furthermore, the film was dipped in an etching solution for copper for about 5 hours, and thereafter the heat decomposition temperature and the mechanical properties of the film were measured to obtain nearly the same values as those of the film which was not dipped in the etching solution, and thus this film was chemically very stable.

It can be seen from the above results that if the imidization of the polyamic acid is conducted without contact with copper or silver, the film has very excellent properties.

### Comparative Example 3

In the same manner as in Example 1, a thin copper film was vapor deposited onto a silicon wafer, a pattern was formed by etching, and thereon was coated the same polyamic acid varnish as used in Comparative Example 2 which was imidized with heating under the same conditions as in Comparative Example 2. As a result, a discoloration of the polyimide film on the copper pattern to blackish brown occurred, and when the film was peeled, it was torn off from the discolored portion of the copper pattern. Separately, copper was vapor deposited on to a silicon wafer as above and then, a polyamic acid varnish was coated thereon without forming a pattern and was imidized by heating. Thereafter, this film was dipped in an etching solution for copper, and the film was then peeled therefrom. The content of copper in this film was very high, namely, 0.3%. This film had a heat decomposition starting temperature of 330°C and thus was inferior in heat resistance by nearly 200°C as compared with the film formed on an inert substrate, and besides, the film strength and the breaking extension were 150 MPA and 3%, respectively, and thus much deteriorated. These results seem to be caused by dissolution of copper due to the presence of carboxylic acid groups in the polyamic acid which is the polyimide precursor, and the deterioration of imide rings due to oxidation with copper in the film. It can be clearly seen from the comparison of Comparative Examples 1 and 2 that when the polyamic acid is imidized by heating in contact with copper, the heat resistance is sharply reduced.

### Comparative Example 4

In place of copper used in Comparative Example 2, a silver film was formed on a silicon wafer by vapor deposition, and the same polyamic acid varnish as in Comparative Example 2 was coated thereon and imidized by heating. The polyimide film peeled therefrom had a heat decomposition starting temperature of 400°C which was better than when the film was formed on a copper film, but was inferior in the heat resistance by nearly 100°C as compared with the film formed on an inert substrate, and besides, the film was much inferior in film strength and breaking extension, which were 220 kPa and 6%, respectively. These results seen to be caused by dissolution of silver due to the presence of carboxylic acid groups in the polyamic acid which is the polyimide precursor, and the deterioration of imide rings by oxidation with silver in the film. The heat resistance of the polyimide was considerably decreased in the case of silver as in the case of copper.

### Comparative Example 5

The same polyamic acid varnish as used in Comparative Example 2 was coated on to a silicon wafer on which a thin copper film was vapor deposited, and imidized by heating in the same manner as in Comparative Example 2 except that the atmosphere for the curing was not air, but a nitrogen gas containing a small amount of hydrogen, namely, a slightly reducing atmosphere. As a result, no change was seen in the polyimide film. The heat decomposition starting temperature of the polyimide film obtained by removing the copper by etching was 500°C, showing that the heat decomposition characteristic of this film was at markedly higher temperatures than that of the film imidized by heating in air, and nearly the same as that of the film cured on an inert substrate. Besides, the film strength and the breaking extension were 350 MPa and 21%, respectively, and thus were somewhat inferior to those of the polyimide film formed on the SiO₂ film, but it was recognized that the film was subject to substantially no influence of copper. It seems that copper was dissolved due to the presence of carboxylic acid groups in the polyamic acid which is the polyimide precursor, but the copper in the film became inert by the heat treatment in the reducing atmosphere.

## Claims

1. A process for producing copper or silver/polyimide composite articles, comprising the steps of
providing a precursor of a polyimide in contact with the copper or silver (2)
and
heating the precursor until it turns into the polyimide (3),
wherein the precursor is a polyamic acid ester of the general formula I, 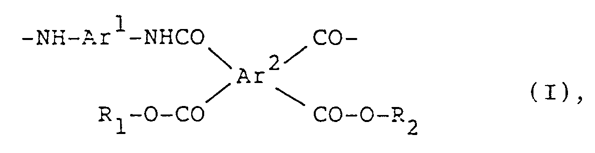 wherein R₁ and R₂ are the same or different alkyl groups having one or more carbon atoms, Ar¹ is a bivalent aromatic group, and Ar² is a tetravalent aromatic group.

2. A process for producing printed circuit boards, comprising the steps of
forming a copper film (2) on an electrically insulating substrate (1),
coating a precursor of a polyimide on the copper film (2), and heating the precursor until it turns into the polyimide (3),
wherein the precursor is a polyamic acid ester of the general formula I, 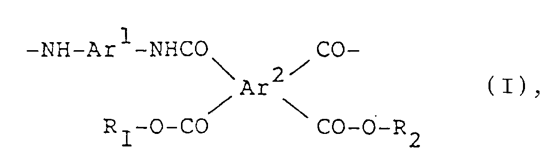 wherein R₁ and R₂ are the same or different alkyl groups having one or more carbon atoms, Ar¹ is a bivalent aromatic group, and Ar² is a tetravalent aromatic group.

3. A process for producing copper or silver/polyimide compositions, comprising the steps of
providing a homogeneous mixture of a precursor of a polyimide, minute particles of copper or silver and an organic solvent for dissolving the precursor,
and
heating the precursor until it turns into the polyimide (3),
wherein the precursor is a polyamic acid ester of the general formula I, 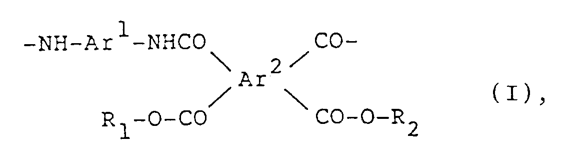 wherein R₁ and R₂ are the same or different alkyl groups having one or more carbon atoms, Ar¹ is a bivalent aromatic group, and Ar² is a tetravalent aromatic group.

4. A process for producing multi-layer printed circuit boards which comprises the following steps:
(A) Forming a circuit pattern of a copper film (2) on an electrically insulating substrate (1),
(B) coating a varnish of a precursor of a polyimide on the circuit pattern,
(C) heating the varnish until the precursor turns into the polyimide (3),
(D) patterning the polyimide (3) to form through-holes therein,
and
(E) forming a circuit pattern of copper (2) on the patterned polyimide (3),
the steps A to E being repeated until a desired number of layers is obtained,
wherein the precursor is a polyamic acid ester of the general formula I, 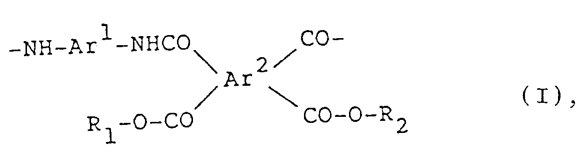 wherein R₁ and R₂ are the same or different alkyl groups having one or more carbon atoms, Ar¹ is a bivalent aromatic group, and Ar² is a tetravalent aromatic group.

5. The process according to one of claims 1 to 4, wherein the number of carbon atoms of R₁ and R₂ is 1 to 20.

## Patentansprüche

1. Verfahren zur Herstellung von Kupfer- oder Silber-Polyimid-Verbundgegenständen, das folgende Schritte umfaßt: Bereitstellen eines Polyimid-Vorläufers in Kontakt mit Kupfer oder Silber (2)
und
Erhitzen des Vorläufers bis zu seiner Umwandlung in das Polyimid (3),
wobei der Vorläufer ein Polyamidsäureester der allgemeinen Formel I 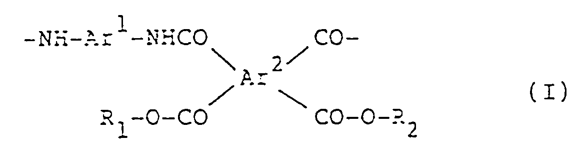 ist, worin R₁ und R₂ gleiche oder verschiedene Alkylgruppen mit einem oder mehreren Kohlenstoffatomen, Ar¹ eine zweiwertige aromatische Gruppe und Ar² eine vierwertige aromatische Gruppe sind.

2. Verfahren zur Herstellung gedruckter Leiterplatten, das folgende Schritte umfaßt:
Erzeugen eines Kupferfilms (2) auf einem elektrisch isolierenden Substrat (1),
Beschichten des Kupferfilms (2) mit einem Polyimid-Vorläufer und Erhitzen des Vorläufers bis zu seiner Umwandlung in das Polyimid (3),
wobei der Vorläufer ein Polyamidsäureester der allgemeinen Formel I 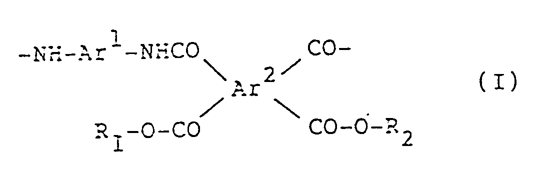 ist, worin R₁ und R₂ gleiche oder verschiedene Alkylgruppen mit einem oder mehreren Kohlenstoffatomen, Ar¹ eine zweiwertige aromatische Gruppe und Ar² eine vierwertige aromatische Gruppe sind.

3. Verfahren zur Herstellung von Kupfer- oder Silber-Polyimid-Zusammensetzungen, das folgende Schritte umfaßt: Erzeugen eines homogenen Gemischs aus einem Polyimid-Vorläufer, feinen Kupfer- oder Silberteilchen und einem organischen Lösungsmittel zum Lösen des Vorläufers und Erhitzen des Vorläufers bis zu seiner Umwandlung in das Polyimid (3),
wobei der Vorläufer ein Polyamidsäureester der allgemeinen Formel I 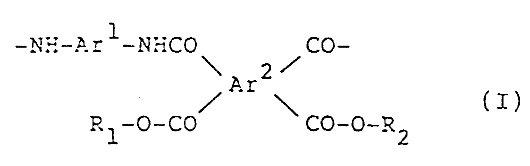 ist, worin R₁ und R₂ gleiche oder verschiedene Alkylgruppen mit einem oder mehreren Kohlenstoffatomen,
Ar¹ eine zweiwertige aromatische Gruppe und Ar² eine vierwertige aromatische Gruppe sind.

4. Verfahren zur Herstellung mehrlagiger gedruckter Leiterplatten durch
(A) Erzeugen eines Schaltungsmusters aus einem Kupferfilm (2) auf einem elektrisch isolierenden Substrat (1),
(B) Beschichten des Schaltungsmusters mit einem Lack aus einem Polyimid-Vorläufer,
(C) Erhitzen des Lacks, bis der Vorläufer in das Polyimid (3) umgewandelt ist,
(D) Ausbildung eines Musters des Polyimids (3) zur Erzeugung von Durchgangslöchern
und
(E) Erzeugen eines Schaltungsmusters aus Kupfer (2) auf dem mit Muster versehenen Polyimid (3),
wobei die Schritte A bis E wiederholt werden, bis die gewünschte Anzahl an Schichten erhalten ist, und wobei der Vorläufer ein Polyamidsäureester der allgemeinen Formel I 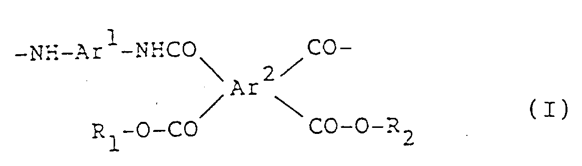 ist, worin R₁ und R₂ gleiche oder verschiedene Alkylgruppen mit einem oder mehreren Kohlenstoffatomen, Ar¹ eine zweiwertige aromatische Gruppe und Ar² eine vierwertige aromatische Gruppe sind.

5. Verfahren nach einem der Ansprüche 1 bis 4,
wobei die Anzahl der Kohlenstoffatome in R₁ und R₂ 1 bis 20 beträgt.

## Revendications

1. Procédé de production d'articles composites cuivre ou argent/polyimide, comprenant les étapes consistant à
mettre en contact un précurseur d'un polyimide avec le cuivre ou l'argent (2)
et
à chauffer le précurseur jusqu'à ce qu'il se transforme en le polyimide (3),
dans lequel le précurseur est un ester d'acide polyamique de formule générale (I), 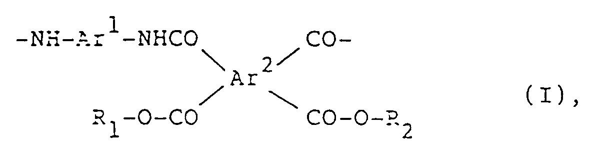 dans laquelle R₁ et R₂ représentent des groupes alkyle identiques ou différents ayant un ou plusieurs atomes de carbone, Ar¹ représente un groupe aromatique bivalent, et Ar² représente un groupe aromatique tétravalent.

2. Procédé de production de plaquettes à circuits imprimés, comprenant les étapes consistant à
former un film de cuivre (2) sur un substrat
électriquement isolant (1),
revêtir d'un précurseur d'un polyimide le film de cuivre (2), et chauffer le précurseur jusqu'à ce qu'il se transforme en le polyimide (3),
dans lequel le précurseur est un ester d'acide polyamique de formule générale (I), 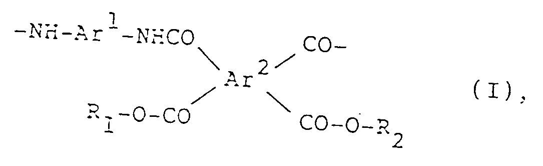 dans laquelle R₁ et R₂ représentent des groupes alkyle identiques ou différents ayant un ou plusieurs atomes de carbone, Ar¹ représente un groupe aromatique bivalent, et Ar² représente un groupe aromatique tétravalent.

3. Procédé de production de compositions cuivre ou argent/polyimide, comprenant les étapes consistant à
réaliser un mélange homogène d'un précurseur d'un polyimide, de fines particules de cuivre ou d'argent, et d'un solvant organique pour dissoudre le précurseur,
et
à chauffer le précurseur jusqu'à ce qu'il se transforme en le polyimide (3),
dans lequel le précurseur est un ester d'acide polyamique de formule générale (I), 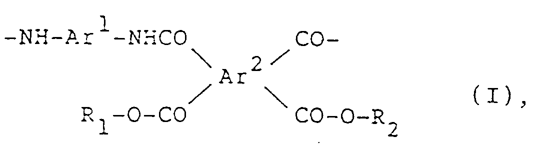 dans laquelle R₁ et R₂ représentent des groupes alkyle identiques ou différents ayant un ou plusieurs atomes de carbone, Ar¹ représente un groupe aromatique bivalent, et Ar² représente un groupe aromatique tétravalent.

4. Procédé de production de plaquettes à circuits imprimés multi-couches, qui comprend les étapes suivantes :
(A) formation d'un circuit imprimé en un film de cuivre (2) sur un substrat électriquement isolant (1),
(B) dépôt d'un vernis d'un précurseur d'un polyimide sur le circuit imprimé,
(C) chauffage du vernis jusqu'à ce que le précurseur se transforme en le polyimide (3),
(D) impression du polyimide (3) pour y former des trous débouchants,
et
(E) formation d'un circuit imprimé de cuivre (2) sur le polyimide imprimé (3),
les étapes A à E étant répétées jusqu'à l'obtention du nombre de couches voulu,
dans lequel le précurseur est un ester d'acide polyamique de formule générale (I), 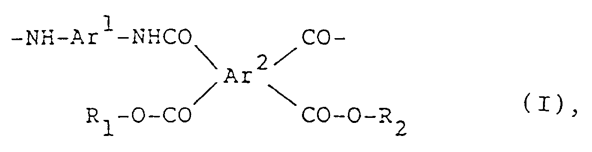 dans laquelle R₁ et R₂ représentent des groupes alkyle identiques ou différents ayant un ou plusieurs atomes de carbone, Ar¹ représente un groupe aromatique bivalent, et Ar² représente un groupe aromatique tétravalent.

5. Procédé selon l'une des revendications 1 à 4, dans lequel le nombre d'atomes de carbone de R₁ et de R₂ est compris dans la gamme de 1 à 20.
